(19) Europäisches Patentamt

European Patent Office

Office européen des brevets

(11) **EP 2 003 461 B1**

(12) **FASCICULE DE BREVET EUROPEEN**

(45) Date de publication et mention de la délivrance du brevet:
**19.10.2016 Bulletin 2016/42**

(21) Numéro de dépôt: **08103852.3**

(22) Date de dépôt: **07.05.2008**

(51) Int Cl.:
*H02M 3/337* *(2006.01)*     *H02H 7/09* *(2006.01)*
*G01R 31/34* *(2006.01)*     *H02P 21/00* *(2016.01)*
*H02M 1/32* *(2007.01)*

(54) **Procédé pour détecter la perte de une ou plusieurs phases dans un moteur électrique synchrone à aimants permanents**

Verfahren zum Feststellen eines Ausfalls einer oder mehrerer Phasen bei einem Dauermagnet-Synchronmotor

Method for detecting the loss of one or more phases in a permanent-magnet synchronous electric motor

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **25.05.2007 FR 0755258**

(43) Date de publication de la demande:
**17.12.2008 Bulletin 2008/51**

(73) Titulaire: **Schneider Toshiba Inverter Europe SAS 27120 Pacy sur Eure (FR)**

(72) Inventeurs:
- **Capitaneanu, Stéfan**
  **27220, Mosseaux Neuville (FR)**
- **Jadot, Fabrice**
  **27120, Pacy-Sur-Eure (FR)**
- **Kermarrec, Ludovic**
  **27000, Evreux (FR)**
- **Malrait, François**
  **27120, Jouy Sur Eure (FR)**

(74) Mandataire: **Dufresne, Thierry et al Schneider Electric Industries SAS Service Propriété Industrielle 35 rue Joseph Monier - CS 30323 92506 Rueil-Malmaison Cedex (FR)**

(56) Documents cités:
US-A- 5 677 606     US-A1- 2006 186 914
US-B1- 6 459 999     US-B1- 6 611 771

## Description

La présente invention se rapporte à un procédé mis en oeuvre dans un variateur de vitesse pour détecter une perte d'une phase, de deux phases ou de trois phases dans un moteur électrique synchrone à aimants permanents. Ce procédé est mis en oeuvre en boucle fermée, c'est-à-dire avec mesure de vitesse ou de position dans le moteur. L'invention concerne également un variateur de vitesse susceptible de mettre en oeuvre le procédé défini ci-dessus.

Dans un système comportant un moteur électrique et un variateur de vitesse, la perte de une ou plusieurs phases est un phénomène aléatoire. Il peut apparaître en cours de fonctionnement ou à l'arrêt et peut être due par exemple au desserrage des vis occasionné par des vibrations, à une coupure du câble, à un oubli de branchement ou à un contacteur non commandé. La perte d'une ou plusieurs phases peut provoquer des dégâts importants et il est donc important de pouvoir identifier automatiquement la perte de une ou plusieurs phases dans le moteur.

Le brevet US 7,161,375 décrit une méthode pour détecter la perte d'une phase dans un moteur à aimants permanents fonctionnant en boucle ouverte. Cette méthode ne fonctionne que lorsque le moteur est initialement à l'arrêt et consiste à injecter un courant de couple dans les enroulements du moteur, à mesurer un courant dans une phase du moteur, à comparer la valeur de courant déterminée avec une valeur calculée et à décider de la perte de phase si la différence entre le courant mesuré et la valeur calculée est supérieure à une valeur prédéterminée. La solution évoquée dans ce brevet ne permet pas de détecter la perte de toutes les phases en même temps. En outre, elle est mise en oeuvre lors de la phase de démarrage du moteur après avoir positionné le moteur à l'arrêt dans une position déterminée.

Le but de l'invention est de proposer un procédé pour détecter la perte d'une ou plusieurs phases du moteur lorsque celui-ci est en marche ou à l'arrêt et sans affecter le contrôle du couple, c'est-à-dire sans générer d'oscillations supplémentaires ou de perte de couple.

Ce but est atteint par un procédé mis en oeuvre dans un variateur de vitesse pour détecter une perte d'une phase, de deux phases ou de trois phases dans un moteur synchrone triphasé à aimants permanents en marche ou stoppé à l'arrêt, ledit variateur exécutant une commande fonctionnant en boucle fermée, ledit procédé étant caractérisé en ce qu'il comporte des étapes de :

- détermination d'un courant de flux de référence en fonction d'un courant de couple de référence, ledit courant de couple de référence étant calculé à partir d'une vitesse de référence à appliquer au moteur et d'une mesure de la vitesse ou de position réalisée sur le moteur,

- application du courant de flux de référence en vue d'injecter des courants sur les différentes phases du moteur,

- mesure des courants sur au moins deux phases et détermination de la perte d'une phase, de deux phases ou de trois phases à partir de ces courants mesurés.

Selon une particularité, la perte d'une phase, de deux phases ou de trois phases est déterminée à l'issue d'une durée prédéfinie.

Selon une autre particularité, le courant de flux de référence est appliqué suivant une rampe de commande inférieure à la durée prédéfinie.

Selon une autre particularité, si aucun courant de couple de référence n'est appliqué, un courant de flux de référence minimum est appliqué pour pouvoir détecter la perte de phases dans le moteur.

Selon une autre particularité, le courant de flux de référence est incrémenté jusqu'à une valeur finale suivant une rampe de commande tant que le courant de couple de référence est inférieure à ladite valeur finale.

Selon une autre particularité, le courant de flux de référence est décrémenté jusqu'à zéro suivant une rampe de commande à partir du moment ou le courant de couple de référence est supérieur à une valeur déterminée.

Selon l'invention, Pour détecter la perte des trois phases lorsque le moteur est en marche, le procédé comporte également des étapes de :

- détermination du module du courant efficace des courants injectés sur les trois phases,

- comparaison du module du courant efficace déterminé avec une valeur prédéterminée,

- détermination de la perte des trois phases du moteur en marche lorsque le module du courant efficace est restée inférieur à la valeur prédéterminée pendant une durée prédéfinie.

Pour détecter la perte d'une ou plusieurs phases lorsque le moteur est stoppé à l'arrêt, le procédé comporte des étapes de :

- détermination du module de la tension efficace à appliquer au moteur,

- comparaison du module de la tension efficace avec une valeur prédéterminée,

- détermination de la perte d'une ou plusieurs phases du moteur stoppé à l'arrêt lorsque le module de la tension efficace est restée supérieur à la valeur prédéterminée pendant une durée prédéfinie.

Lorsque le moteur est stoppé à l'arrêt, il comporte une étape de détermination d'un courant de flux à partir des courants injectés sur chaque phase et une étape d'application de ce courant de flux avec un angle prédéfini.

Pour détecter la perte d'une phase lorsque le moteur est en marche, le procédé comporte des étapes de :

- obtention de l'angle du repère tournant de la commande,

- comparaison du module du courant efficace appliqué sur chaque phase avec une valeur prédéterminée,

- en fonction de la comparaison, affectation on non, de l'angle du repère tournant à chacun des angles des courants injectés sur les différentes phases du moteur,

- étude de la variation de chacun des angles au cours du temps et détermination de la perte d'une phase du moteur en marche en fonction de cette étude.

L'invention concerne également un variateur de vitesse apte à mettre en oeuvre une commande fonctionnant en boucle fermée pour commander un moteur électrique synchrone à aimants permanents, ledit variateur étant apte à mettre en oeuvre le procédé défini ci-dessus.

L'idée principale de l'invention est donc d'appliquer un courant dans la direction du flux sans affecter le contrôle du couple, c'est-à-dire sans générer d'oscillations supplémentaires ou de perte de couple.

Le moteur est stoppé à l'arrêt, frein serré, dans des applications de type ascenseur ou levage. Dans ce cas, il est important de savoir que le moteur est bien connecté avant de libérer le frein car sinon une perte de charge est possible. La détection de la perte d'une ou plusieurs phases du moteur doit donc être mise en oeuvre dans le variateur avant le démarrage de la rampe d'accélération.

D'autres caractéristiques et avantages vont apparaître dans la description détaillée qui suit en se référant à un mode de réalisation donné à titre d'exemple et représenté par les dessins annexés sur lesquels :

- la figure 1 représente le schéma synoptique de la commande mise en oeuvre dans le variateur de vitesse pour commander le moteur synchrone à aimants permanents.

- Les figures 2 et 3 illustrent les critères mis en oeuvre pour détecter la perte d'une ou plusieurs phases dans le moteur.

L'invention consiste à détecter la perte de une ou plusieurs phases dans un moteur électrique synchrone à aimants permanents PMSM en marche ou à l'arrêt. Elle est mise en oeuvre dans un variateur de vitesse mettant en oeuvre une commande fonctionnant en boucle fermée, c'est-à-dire avec détection de vitesse ou de la position réalisée dans le moteur PMSM.

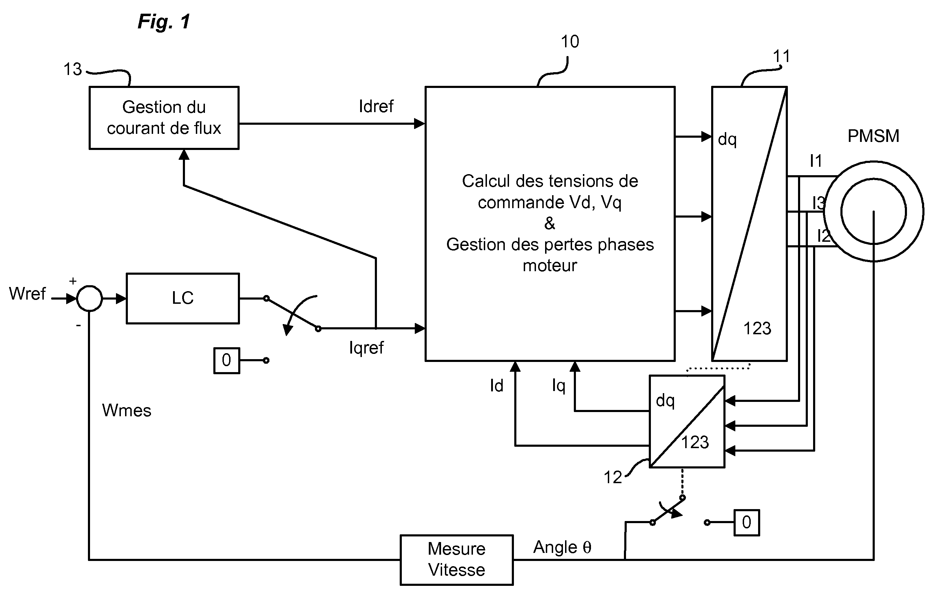

En référence à la figure 1, dans la commande mise en oeuvre dans un variateur de vitesse 1 pour moteur électrique synchrone à aimants permanents PMSM, il est connu d'envoyer une vitesse de référence Wref, de déterminer un courant de couple de référence Iqref à partir de la loi de commande en vitesse LC employée et du retour de la mesure de vitesse Wmes, par exemple issue d'un calcul à partir d'un retour de position lorsque l'on fonctionne en boucle fermée. Le courant de couple de référence Iqref ainsi déterminé est envoyé dans un bloc de commande 10 permettant de déterminer des tensions de commande Vq et Vd. Ces tensions de commande Vd, Vq sont appliquées dans un bloc de commande 11 les transformant, par exemple par la transformation de Park, en courant de commande 11, 12, 13 à appliquer sur les trois phases du moteur à aimants permanents PMSM.

L'invention consiste à injecter dans la commande du moteur un courant de flux de référence Idref dont la valeur dépend du courant de couple de référence Iqref déterminé. Ce courant de flux de référence Idref est donc appliqué dans la direction du flux permanent de l'aimant du moteur PMSM, c'est-à-dire suivant l'axe d de la commande, dit axe de flux. Il ne doit être appliqué que lorsqu'un courant de couple n'est pas suffisant pour l'identification de la perte de phases moteur. Le courant de flux Idref est ainsi appliqué suivant une rampe de commande déterminée jusqu'à atteindre une valeur finale $IdOPF_{cont}$. Tant que le courant de couple de référence Iqref est inférieur à cette valeur finale $IdOPF_{cont}$, le courant de flux de référence Idref est incrémenté suivant sa rampe de commande jusqu'à atteindre sa valeur finale $IdOPF_{cont}$. Le courant de flux de référence Idref reste à cette valeur $IdOPF_{cont}$ si le courant de couple de référence Iqref n'a pas dépassé la valeur de $IdOPF_{cont}$. $IdOPF_{cont}$ vaut par exemple 10% du courant nominal du moteur M. Cette valeur peut être ajustée en fonction de la puissance du variateur de vitesse utilisé. En revanche, tant que le courant de couple de référence Iqref est supérieur à la valeur $IdOPF_{cont}$, le courant de flux de référence Idref est décrémenté suivant la même rampe de commande jusqu'à valoir zéro. Sur la figure 1, la gestion du courant de flux de référence Idref est réalisée dans le bloc de commande 13 du schéma synoptique.

La rampe de commande du courant de flux de référence est choisie inférieure à la durée de la séquence de détection de la perte phases. Selon les cas, la rampe de commande est par exemple de 100 millisecondes ou de 20 millisecondes. La durée prédéfinie de la séquence de détection est par exemple de 500 millisecondes.

Selon l'invention, l'application d'un courant dans la direction du flux de l'aimant permet de ne pas créer de perturbations dans le moteur lorsqu'il est en marche. En effet, l'injection d'un courant de flux ne crée pas d'oscillations de couple supplémentaires car le courant est appliqué suivant des rampes longues par rapport à la dynamique du système mais courtes par rapport au temps de détection du défaut. Par ailleurs, il n'existe pas de perte de couple car le courant de flux de référence Idref n'est appliqué que lorsque le courant de couple de référence Iqref est faible.

Selon l'invention, afin de détecter la perte de une phase, deux phases ou trois phases lorsque le moteur est en marche ou stoppé à l'arrêt, le variateur de vitesse met en oeuvre différentes étapes tenant compte de différents critères déterminés exécutés par le variateur de vitesse.

La détermination de la perte de une ou plusieurs phases est réalisée grâce à la mesure des courants I1, I2, I3 injectés sur les trois phases du moteur. Il est également possible de mesurer les courants sur deux phases seulement et de reconstituer le troisième courant.

Les courants I1, I2, I3 obtenus sont traités et transformés dans un bloc de commande 12 de manière à obtenir un courant de composante d et un courant de composante q. Les deux courants Id, Iq ainsi déterminés sont appliqués dans le bloc de commande 10 en vue de participer à la détermination des tensions de commande Vd, Vq en fonction du courant de couple de référence Iqref et du courant de flux de référence Idref.

Pour la détection de la perte des trois phases lorsque le moteur est en marche, la condition suivante est appliquée. Si le module du courant efficace Ieff, égal à $\sqrt{\mathrm{Id}^2 + \mathrm{Iq}^2}$ , appliqué sur les trois phases du moteur reste inférieur à une valeur limite IdOPF$_{diag}$ du courant de flux de référence Idref, pendant une durée prédéfinie, par exemple de 500 millisecondes, le défaut de perte des trois phases est identifié.

Un compteur de temps peut être employé pour réaliser cette fonction. Le compteur s'incrémente à chaque fois que la condition est remplie et se décrémente lorsque la condition n'est pas remplie. Lorsque le compteur de temps a atteint la durée prédéfinie, cela signifie qu'aucune des trois phases du moteur n'est connectée au variateur de vitesse.

Selon l'invention, IdOPF$_{diag}$ peut être égal à IdOPF$_{cont}$ mais pour plus de robustesse dans la détection, IdOPF$_{diag}$ est choisi supérieur à IdOPF$_{cont}$, avec par exemple IdOPF$_{diag}$=1,5 X IdOPF$_{cont}$

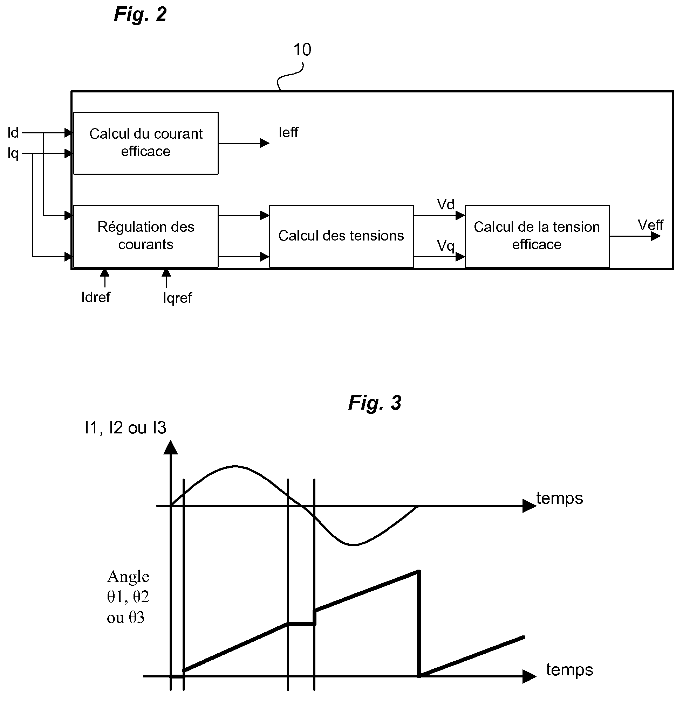

Lorsque le moteur est stoppé à l'arrêt, c'est-à-dire avec le frein serré, la condition de détermination de la perte des trois phases est différente. Dans ce cas, il s'agit de comparer le module de la tension efficace Veff à appliquer au moteur avec une valeur limite prédéfinie, désignée ci-après UOPF égale par exemple à 37,5% de la tension fournie sur le bus continu du variateur de vitesse. De manière connue, le module de la tension efficace Veff est égal à $\sqrt{\mathrm{Vd}^2 + \mathrm{Vq}^2}$ ; la tension de couple Vq et la tension de flux Vd étant déterminées à partir des courants Idref, Iqref et des courants Id et Iq issus des mesures des courants I1, I2, I3 (figure 2). Ainsi, si le module de la tension efficace Veff appliquée au moteur est plus grand que la valeur limite UOPF, cela signifie qu'aucune des trois phases du moteur PMSM n'est connectée au variateur de vitesse 1.

Pour la détermination de la perte d'une phase ou de deux phases, les critères de détermination sont différents étant donné qu'un courant circule toujours dans le moteur même si une phase est manquante.

Lorsque le moteur PMSM est en marche, la détection de la perte d'une phase est réalisée en étudiant la variation des angles des courants mesurés.

Pour chaque phase, si le module du courant mesuré sur chaque phase, I1, I2 ou I3 est supérieur à une valeur IOPF$_{123}$, l'angle θ1, θ2, θ3 de chacun des courants prend la valeur mesurée de l'angle θ du repère tournant de la commande. L'angle θ est récupéré à partir de la mesure de vitesse ou de position réalisée sur le moteur par des méthodes connues (figure 1). En revanche, si le module du courant mesuré sur chacune des phases est inférieur à la valeur IOPF$_{123}$, l'angle θ1, θ2, θ3 de chacun des courants conserve sa valeur antérieure qui est la dernière valeur correspondante où le module du courant mesuré sur chaque phase était supérieur à la valeur IOPF$_{123}$. IOPF$_{123}$ peut être une valeur prédéfinie, fonction du courant nominal du moteur ou, pour plus de robustesse, peut être variable en fonction du courant efficace (Ieff) calculé à partir des courants I1, I2, I3 mesurés. Dans ce dernier cas, IOPF$_{123}$ est par exemple égal au courant efficace Ieff divisé par quatre.

Ensuite, il s'agit d'étudier la variation au cours du temps de chacun des angles θ1, θ2, θ3 par rapport à θ. Si les angles θ1, θ2, θ3 varient peu ou pas du tout par rapport à θ pendant une durée prédéfinie, par exemple de 500 millisecondes, alors la perte de phase peut être identifiée sur la phase 1, sur la phase 2 ou sur la phase 3. Comme précédemment un compteur de temps peut être utilisé pour chaque phase. Ce compteur est incrémenté ou décrémenté si la condition est remplie ou non.

En résumé :

Si |I$_{231}$| > IOPF$_{123}$| alors l'angle θ1, θ2 ou θ3 est égal à θ,

Si |I$_{123}$| ≤ IOPF$_{123}$| alors l'angle θ1, θ2 ou θ3 conserve sa valeur antérieure.

Si |θ1-θ| ou |θ2-θ| ou |θ3-θ|>θmin pendant une durée prédéfinie, par exemple de 500 millisecondes, la perte de la phase 1, de la phase 2 ou de la phase 3 est identifiée. On choisit par exemple θmin égal à π/2.

La figure 3 montre la variation d'un angle θ1, θ2 ou θ3 en fonction du courant sinusoïdal mesuré I1, I2 ou I3 correspondant. Sur cette figure 3, on remarque que lorsque le courant est faible, la valeur de l'angle θ1, θ2 ou θ3 correspondante reste constante.

Lorsque le moteur est stoppé à l'arrêt, frein serré, et lorsqu'une ou deux phases ne sont pas correctement connectées, les tensions de commande Vd, Vq atteignent rapidement des niveaux inadmissibles. Ainsi comme pour la détection de la perte de trois phases lorsque le moteur est en marche, le module de la tension efficace Veff devient supérieur à une valeur UOPF prédéterminée. Si cette condition est remplie pendant une durée prédéfinie, par exemple 500 millisecondes, il est possible de conclure à la perte d'une phase. Dans cette situation, comme les courants injectés sont sinusoïdaux, il faut pouvoir être sûr de ne pas obtenir un courant nul sur une phase alors qu'il ne l'est pas et conclure à la perte de phase alors que ce n'est pas le cas. Selon l'invention, le courant de flux Id qui est injecté dans le bloc de commande 10 est alors orienté suivant un angle prédéfini, par exemple de valeur zéro, pour lequel on est sûr que l'on obtiendrait du courant si les trois phases étaient correctement connectées. L'angle est maintenue à cette valeur pendant la mise en oeuvre du procédé de détection.

Comme le frein est serré, la dynamique du courant de flux de référence n'affecte pas la dynamique du couple, de ce fait, le courant de flux de référence Idref peut atteindre le niveau de courant $IdOPF_{cont}$ suivant une rampe de commande plus courte que lorsque le moteur est en marche, par exemple de 20 millisecondes. Il est également possible de conférer à $IdOPF_{cont}$ une valeur plus importante par exemple de l'ordre du courant nominal du moteur.

Il est bien entendu que l'on peut, sans sortir du cadre de l'invention, imaginer d'autres variantes et perfectionnements de détail et de même envisager l'emploi de moyens équivalents.

## Revendications

1. Procédé mis en oeuvre dans un variateur de vitesse (1) pour détecter une perte d'une phase, de deux phases ou de trois phases dans un moteur synchrone triphasé à aimants permanents (PMSM) en marche ou stoppé à l'arrêt, ledit variateur exécutant une commande fonctionnant en boucle fermée, ledit procédé étant **caractérisé en ce qu'**il comporte des étapes de :

   - détermination d'un courant de flux de référence (Idref) en fonction d'un courant de couple de référence (Iqref), ledit courant de couple de référence (Iqref) étant calculé à partir d'une vitesse de référence (Wref) à appliquer au moteur et d'une mesure de la vitesse (Wmes) ou de position réalisée sur le moteur,
   - application du courant de flux de référence (Idref) en vue d'injecter des courants (I1, I2, I3) sur les différentes phases du moteur (PMSM),

   - mesure des courants sur au moins deux phases et détermination de la perte d'une phase, de deux phases ou de trois phases à partir de ces courants mesurés.

2. Procédé selon la revendication 1, **caractérisé en ce que** la perte d'une phase, de deux phases ou de trois phases est déterminée à l'issue d'une durée prédéfinie.

3. Procédé selon la revendication 2, **caractérisé en ce que** le courant de flux de référence est appliqué suivant une rampe de commande inférieure à la durée prédéfinie.

4. Procédé selon l'une des revendications 1 à 3, **caractérisé en ce que** si aucun courant de couple de référence n'est appliqué, un courant de flux de référence minimum est appliqué pour pouvoir détecter la perte de phases.

5. Procédé selon l'une des revendications 1 à 4, **caractérisé en ce que** le courant de flux de référence (Idref) est incrémenté jusqu'à une valeur finale ($IdOPF_{cont}$) suivant une rampe de commande tant que le courant de couple de référence (Iqref) est inférieure à ladite valeur finale ($IdOPF_{cont}$).

6. Procédé selon l'une des revendications 1 à 5, **caractérisé en ce que** le courant de flux de référence est décrémenté jusqu'à zéro suivant une rampe de commande à partir du moment ou le courant de couple de référence est supérieur à une valeur déterminée ($IdOPF_{cont}$).

7. Procédé selon la revendication 1, **caractérisé en ce qu'**il comporte des étapes de :

   - détermination du module du courant efficace (Ieff) des courants injectés (I1, I2, I3) sur les trois phases,
   - comparaison du module du courant efficace (Ieff) déterminé avec une valeur prédéterminée ($IdOPF_{diag}$),
   - détermination de la perte des trois phases du moteur en marche lorsque le module du courant efficace (Ieff) est restée inférieure à la valeur prédéterminée ($IdOPF_{diag}$) pendant une durée prédéfinie.

8. Procédé selon la revendication 1, **caractérisé en ce qu'**il comporte des étapes de :

   - détermination du module de la tension efficace (Veff) à appliquer au moteur (PMSM),
   - comparaison du module de la tension efficace (Veff) avec une valeur prédéterminée (UOPF),
   - détermination de la perte d'une ou plusieurs phases du moteur stoppé à l'arrêt lorsque le module de la tension efficace (Veff) est restée supérieure à la valeur prédéterminée (UOPF) pendant une durée prédéfinie.

9. Procédé selon la revendication 8, **caractérisé en ce que** lorsque le moteur est stoppé à l'arrêt, il comporte une étape de détermination d'un courant de flux (Id) à partir des courants injectés (I1, I2, I3) sur chaque phase et une étape d'application de ce courant de flux avec un angle prédéfini.

10. Procédé selon la revendication 1, **caractérisé en ce qu'**il comporte des étapes de :

   - obtention de l'angle ($\theta$) du repère tournant de la commande,
   - comparaison du module du courant efficace (Ieff) appliqué sur chaque phase avec une valeur prédéterminée (IOPF$_{123}$),
   - en fonction de la comparaison, affectation on non, de l'angle du repère tournant à chacun des angles ($\theta$1, $\theta$2, $\theta$3) des courants (11, 12, 13) injectés sur les différentes phases du moteur,
   - étude de la variation de chacun des angles ($\theta$1, $\theta$2, $\theta$3) au cours du temps et détermination de la perte d'une phase du moteur en marche en fonction de cette étude.

11. Variateur de vitesse (1) apte à mettre en oeuvre une commande fonctionnant en boucle fermée pour commander un moteur électrique synchrone à aimants permanents (PMSM), ledit variateur étant apte à mettre en oeuvre le procédé défini dans l'une des revendications 1 à 10.

**Patentansprüche**

1. Verfahren, das in einem Umrichter (1) angewendet wird, um einen Verlust einer Phase, von zwei Phasen oder von drei Phasen in einem ein- oder abgeschalteten Drehstrom-Synchronmotor mit Dauermagneten (PMSM) zu erfassen, wobei der Umrichter eine Steuerung ausführt, die in geschlossenem Regelkreis arbeitet, wobei das Verfahren **dadurch gekennzeichnet ist, dass** es Schritte aufweist:

   - der Bestimmung eines Bezugsflussstroms (Idref) abhängig von einem Bezugsdrehmomentstrom (Iqref), wobei der Bezugsdrehmomentstrom (Iqref) ausgehend von einer an den Motor anzuwendenden Bezugsgeschwindigkeit (Wref) und von einer Messung der Geschwindigkeit (Wmes) oder Positionsmessung, die am Motor durchgeführt wird, berechnet wird,
   - des Anlegens des Bezugsflussstroms (Idref), um Ströme (I1, I2, I3) auf den verschiedenen Phasen des Motors (PMSM) einzuspeisen,
   - der Messung der Ströme an mindestens zwei Phasen und Bestimmung des Verlusts einer Phase, von zwei Phasen oder drei Phasen ausgehend von diesen gemessenen Strömen.

2. Verfahren nach Anspruch 1, **dadurch gekennzeichnet, dass** der Verlust einer Phase, von zwei Phasen oder von drei Phasen nach einer vordefinierten Dauer bestimmt wird.

3. Verfahren nach Anspruch 2, **dadurch gekennzeichnet, dass** der Bezugsflussstrom gemäß einer Steuerrampe niedriger als die vordefinierte Dauer angelegt wird.

4. Verfahren nach einem der Ansprüche 1 bis 3, **dadurch gekennzeichnet, dass**, wenn kein Bezugsdrehmomentstrom angelegt wird, ein minimaler Bezugsflussstrom angelegt wird, um den Phasenverlust erfassen zu können.

5. Verfahren nach einem der Ansprüche 1 bis 4, **dadurch gekennzeichnet, dass** der Bezugsflussstrom (Idref) bis zu einem Endwert (IdOPF$_{cont}$) gemäß einer Steuerrampe inkrementiert wird, so lange der Bezugsdrehmomentstrom (Iqref) niedriger ist als der Endwert (IdOPF$_{cont}$).

6. Verfahren nach einem der Ansprüche 1 bis 5, **dadurch gekennzeichnet, dass** der Bezugsflussstrom gemäß einer Steuerrampe ausgehend von dem Moment bis auf Null dekrementiert wird, in dem der Bezugsdrehmomentstrom höher ist als ein bestimmter Wert (IdOPF$_{cont}$).

7. Verfahren nach Anspruch 1, **dadurch gekennzeichnet, dass** es Schritte aufweist:

   - der Bestimmung des Moduls des Wirkstroms (Ieff) der eingespeisten Ströme (11, 12, 13) auf den drei Phasen,
   - des Vergleichs des Moduls des bestimmten Wirkstroms (Ieff) mit einem vorbestimmten Wert (IdOPF$_{diag}$),
   - der Bestimmung des Verlusts der drei Phasen des eingeschalteten Motors, wenn das Modul des Wirkstroms (Ieff) während einer vordefinierten Dauer niedriger als der vorbestimmte Wert (IdOPF$_{diag}$) geblieben ist.

8. Verfahren nach Anspruch 1, **dadurch gekennzeichnet, dass** es Schritte aufweist:

   - der Bestimmung des Moduls der Wirkspannung (Veff), die an den Motor (PMSM) anzulegen ist,
   - des Vergleichs des Moduls der Wirkspannung (Veff) mit einem vorbestimmten Wert (UOPF),
- der Bestimmung des Verlusts einer oder mehrerer Phasen des abgeschalteten Motors, wenn das Modul der Wirkspannung (Veff) während einer vordefinierten Dauer höher als der vorbestimmte Wert (UOPF) geblieben ist.

9. Verfahren nach Anspruch 8, **dadurch gekennzeichnet, dass** es, wenn der Motor abgeschaltet ist, einen Schritt der Bestimmung eines Flussstroms (Id) ausgehend von den auf jeder Phase eingespeisten Strömen (11, I2, I3) und einen Schritt des Anlegens dieses Flussstroms mit einem vordefinierten Winkel aufweist.

10. Verfahren nach Anspruch 1, **dadurch gekennzeichnet, dass** es Schritte aufweist:

- des Erhalts des Winkels ($\theta$) des drehenden Bezugssystems der Steuerung,
- des Vergleichs des Moduls des auf jeder Phase angelegten Wirkstroms (Ieff) mit einem vorbestimmten Wert ($IOPF_{123}$),
- abhängig vom Vergleich, von der Zuweisung oder nicht des Winkels des drehenden Bezugsystems zu jedem der Winkel ($\theta 1$, $\theta 2$, $\theta 3$) der auf den verschiedenen Phasen des Motors eingespeisten Ströme (11, 12, 13),
- der Untersuchung der Änderung jedes der Winkel ($\theta 1$, $\theta 2$, $\theta 3$) im Lauf der Zeit und Bestimmung des Verlusts einer Phase des eingeschalteten Motors abhängig von dieser Untersuchung.

11. Umrichter (1), der eine Steuerung anwenden kann, die im geschlossenen Regelkreis arbeitet, um einen elektrischen Synchronmotor mit Dauermagneten (PMSM) zu steuern, wobei der Umrichter das in einem der Ansprüche 1 bis 10 definierte Verfahren anwenden kann.

**Claims**

1. Method implemented in a variable speed drive (1) to detect a loss of one phase, two phases or three phases in a three-phase permanent-magnet synchronous motor (PMSM), running or stopped at rest, said variable speed drive executing a closed loop control operation, said method being **characterized in that** it comprises steps of:

- determining a reference flux current (Idref) as a function of a reference torque current (Iqref), said reference torque current (Iqref) being calculated from a reference speed (Wref) to be applied to the motor and a measurement of the speed (Wmes) or the position carried out on the motor;
- applying the reference flux current (Idref) in order to inject currents (I1, 12, 13) over the various phases of the motor (PMSM);
- measuring the currents over at least two phases and determining the loss of one phase, of two phases or of three phases from these measured currents.

2. Method according to Claim 1, **characterized in that** the loss of one phase, of two phases or of three phases is determined after a predefined duration.

3. Method according to Claim 2, **characterized in that** the reference flux current is applied according to a control ramp less than the predefined duration.

4. Method according to one of Claims 1 to 3, **characterized in that** if no reference torque current is applied, a minimum reference flux current is applied in order to be able to detect phase loss.

5. Method according to one of Claims 1 to 4, **characterized in that** the reference flux current (Idref) is incremented up to a final value ($IdOPF_{cont}$) according to a control ramp as long as the reference torque current (Iqref) is less than said final value ($IdOPF_{cont}$).

6. Method according to one of Claims 1 to 5, **characterized in that** the reference flux current is decremented down to zero according to a control ramp from the moment the reference torque current is greater than a determined value ($IdOPF_{cont}$).

7. Method according to Claim 1, **characterized in that** it comprises steps of:

- determining the modulus of the rms current (Irms) of the currents (I1, 12, 13) injected over the three phases;
- comparing the modulus of the rms current (Irms) determined with a predetermined value ($IdOPF_{diag}$);
- determining the loss of three phases of the running motor when the modulus of the rms current (Irms) has remained less than the predetermined value ($IdOPF_{diag}$) for a predefined duration.

8. Method according to Claim 1, **characterized in that** it comprises steps of:

- determining the modulus of the rms voltage (Vrms) to apply to the motor (PMSM);
- comparing the modulus of the rms voltage (Vrms) with a predetermined value (UOPF);
- determining the loss of one or more phases of the motor stopped at rest when the modulus of the rms voltage (Vrms) has remained above the predetermined value (UOPF) for a predefined duration.

9. Method according to Claim 8, **characterized in that** when the motor is stopped at rest, it comprises a step of determining a flux current (Id) from the currents (I1, 12, 13) injected over each phase and a step of applying this flux current with a predefined angle.

10. Method according to Claim 1, **characterized in that** it comprises steps of:

- obtaining the rotating reference angle ($\theta$) of the control;
- comparing the modulus of the rms current (Irms) applied over each phase with a predetermined value ($IOPF_{123}$) ;
- depending on the comparison, assigning or not assigning the rotating reference angle to each of the angles ($\theta1$, $\theta2$, $\theta3$) of the injected currents (I1, 12, 13) over the different phases of the motor;
- studying the variation in each of the angles ($\theta1$, $\theta2$, $\theta3$) over the course of time and determining the loss of a phase of the running motor depending on this study.

11. Variable speed drive (1) able to implement a closed loop control operation to control a permanent-magnet synchronous electric motor (PMSM), said variable speed drive being able to implement the method defined in one of Claims 1 to 10.

*Fig. 1*

PMSM

Calcul des tensions de commande Vd, Vq & Gestion des pertes phases moteur

Gestion du courant de flux

Mesure Vitesse

Idref

Iqref

Wref

Wmes

Angle θ

Id

Iq

LC

dq

123

10

11

12

13

I1

I2

I3

## Fig. 2

10

Id

Iq

| Calcul du courant efficace |

Ieff

| Régulation des courants |

Idref        Iqref

| Calcul des tensions |

Vd

Vq

| Calcul de la tension efficace |

Veff

## Fig. 3

I1, I2 ou I3

temps

Angle
θ1, θ2
ou θ3

temps

**EP 2 003 461 B1**

## RÉFÉRENCES CITÉES DANS LA DESCRIPTION

**Documents brevets cités dans la description**

- US 7161375 B